# EUROPEAN PATENT SPECIFICATION

(11) **EP 0 459 440 B1**
(45) Date of publication and mention of the grant of the patent: **18.09.1996**
(21) Application number: 91108786.4
(22) Date of filing: 29.05.1991
(51) Int. Cl.: H04B 1/04, H02J 7/00

(54) **Radio transmitter apparatus**
Funksendegerät
Dispositif radio-émetteur

(30) Priority: 01.06.1990 JP 144881/90
(43) Date of publication of application: 04.12.1991
(73) Proprietor: SONY CORPORATION, Tokyo (JP)
(72) Inventor: Takao, Nobutaka, Shinagawa-ku Tokyo (JP)
(74) Representative: Melzer, Wolfgang, Dipl.-Ing.

(56) References cited:
- EP-A- 0 280 409
- WO-A-87/02843
- GB-A- 2 167 869
- GB-A- 2 175 700
- US-A- 4 313 060
- US-A- 4 323 788
- US-A- 4 401 894
- US-A- 4 439 744
- US-A- 4 707 620
- *WO-A-91/12671

## Description

The present invention generally relates to transmitting apparatus and, more particularly, is directed to a radio transmitter apparatus.

In a mobile telephone system, for example, a cellular phone system, a base station can control or vary a transmission output of a mobile station because a transmission distance of radio wave from the mobile station to the base station is suppressed to the minimum and the frequency is utilized again to thereby increase telephone subscriber capacity of this phone system.

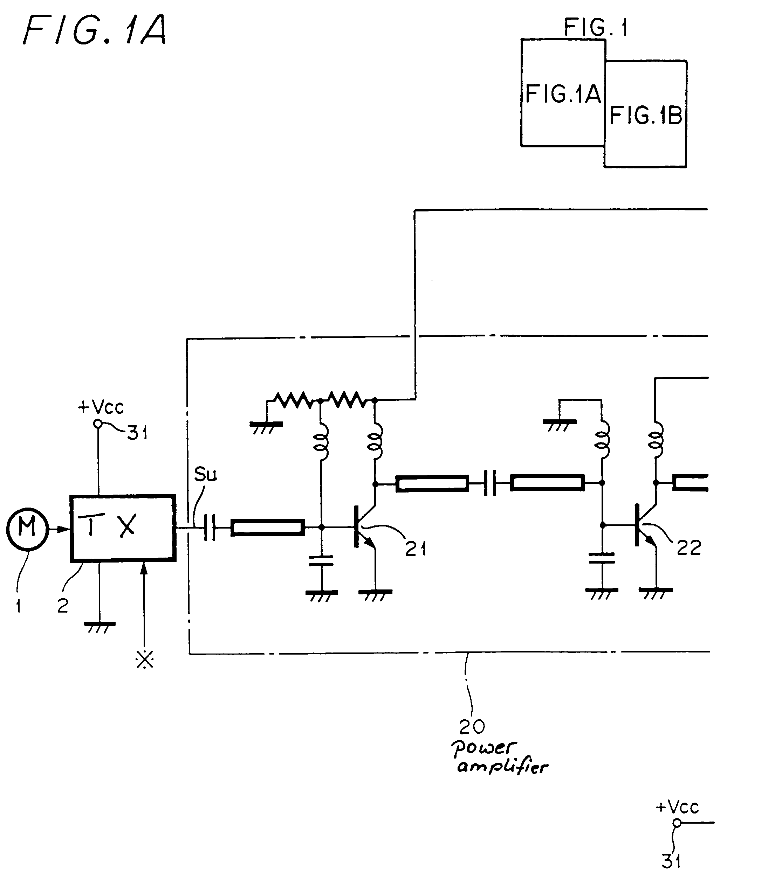

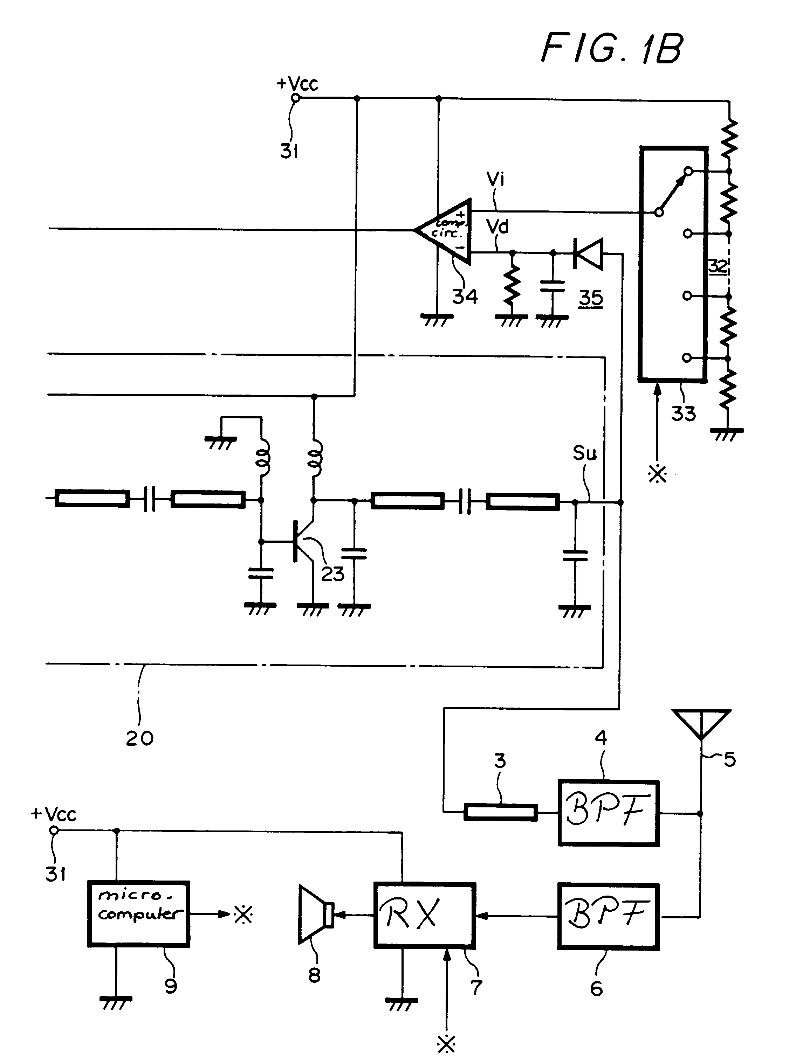

In order that the transmission output may be varied, the mobile station, particularly, the transmission output stage thereof is constructed as shown in, for example, Fig. 1.

In Fig. 1, reference numeral 1 designates a telephone transmitter, 2 a transmitting circuit, 20 a power amplifier fabricated as a module, 3 a strip line, 4 an up-channel bandpass filter, and 5 a transmitting and receiving antenna.

In making an outgoing call, an audio signal from the telephone transmitter 1 is supplied to the transmitting circuit 2, in which it is converted into an FM signal Su of up channel. This FM signal Su is amplified in power by the power amplifier 20 and supplied through the strip line 3 and the bandpass filter 4 to the antenna 5, from which it is transmitted to the base station.

In Fig. 1, reference numeral 6 designates a down channel bandpass filter, 7 a receiving circuit, and 8 a telephone receiver. Upon reception, an FM signal of down channel from the base station is received at the antenna 5, and the received FM signal is supplied through the filter 6 to the receiving circuit 7, from which the audio signal is derived. This audio signal is supplied to the telephone receiver 8.

Further, in Fig. 1, reference numeral 9 designates a microcomputer, and the transmitting circuit 2 and the receiving circuit 7, etc. are controlled by the microcomputer 9.

In the power amplifier 20, reference numerals 21 to 23 designate transistors, and the FM signal Su from the transmitting circuit 2 are sequentially supplied to these transistors 21 to 23 and then supplied to the antenna 5. At that time, the transistor 21 is operated in a class AB fashion and the transistors 22 and 23 are operated in a class C fashion.

Further, a power source voltage + Vcc from a power source terminal 31 is supplied to the circuits 2, 7 and 9 and to the transistors 22 and 23 as an operation voltage.

A voltage dividing circuit 32 is connected between the power source terminal 31 and the ground to derive a plurality of divided voltages V1 to Vn, and these voltages V1 to Vn are supplied to a switching circuit 33. The switching circuit 33 is controlled by the microcomputer 9 and the switching circuit 33 derives a predetermined voltage Vi of these voltages V1 to Vn, this voltage Vi being supplied to a voltage comparing circuit 34.

The FM signal Su from the power amplifier 20 is supplied to a first detecting circuit 35, in which it is converted into a DC voltage Vd of level equal to the level (amplitude) of the FM signal Su. This voltage Vd is supplied to the voltage comparing circuit 34. The compared output of this voltage comparing circuit 34 is supplied to the transistor 21 as an operation voltage.

Accordingly, the voltage is fed back by the voltage comparing circuit 34 so as to establish an equality of Vd = Vi so that the level of the FM signal Su from the power amplifier 20 becomes equal to the level of the voltage Vi. Thus, the level of the FM signal Su can be controlled by controlling the switching circuit 33 by the microcomputer 9, thereby the transmission output being controlled (see Published Searched Application Gazette No. 63-501258).

Incidentally, when this mobile station is used while being carried, this mobile station is driven by a battery housed therein.

When this mobile station is mounted on the automobile and used, the antenna 5 is switched to the antenna of the automobile and the mobile station is driven by a battery of the automobile.

In that case, the incorporated battery and the automobile battery are different in voltage and the voltage of the automobile battery is generally higher than that of the housed battery. Moreover, the transmission output of the mobile station is larger if the mobile station is mounted on the automobile as compared with that of when it is carried.

In the above transmitting circuit 2, the load impedance from the amplifier 20 to the antenna side is constant, for example, 50 n regardless of the change of the transmission output. Further, the power amplifier 20 is generally designed so as to provide maximum efficiency in the case of the maximum transmission output.

Accordingly, when this mobile station is installed on the automobile, the transmission efficiency is maximized, while when the mobile station is carried, the transmission efficiency is lowered.

However, the base station demands the mobile station the transmission output necessary for the telephone communication so that, when the mobile station is carried, the mobile station is operated by the sufficient transmission output as seen from the base station regardless of the lowered efficiency of the base station. Thus, the time for operating the housed battery, that is, the telephone communication time is unavoidably reduced.

It is the object of the present invention to provide a radio transmitter apparatus in which the transmission can be carried out at high efficiency even when a battery voltage is lowered.

The object is solved by the features of claim 1. A further development is defined by the features of claim 2.

The above, features and advantages of the present invention will become apparent in the following detailed description of an illustrative embodiment to be taken in conjunction with the accompanying drawings, in which like reference numerals are used to identify the same or similar parts in the several views.
Fig. 1 is a schematic diagram showing a transmission output stage of a mobile telephone system such as a so-called cellular phone system according to the prior art;
Fig. 2 is a schematic diagram showing an embodiment of a radio transmitter apparatus according to the present invention;
Fig. 3 is a schematic diagram showing a part of a modified embodiment of the radio transmitter apparatus shown in Fig. 2 in which the connected position of an impedance circuit is changed;
Fig. 4 is a schematic diagram showing a part of a modified embodiment of the radio transmitter apparatus according to the present invention in which an impedance is switched when a diode is turned on; and
Fig. 5 is a schematic diagram showing a part of another embodiment of the radio transmitter apparatus according to the present invention in which impedance circuits are connected in a multiple stage fashion.

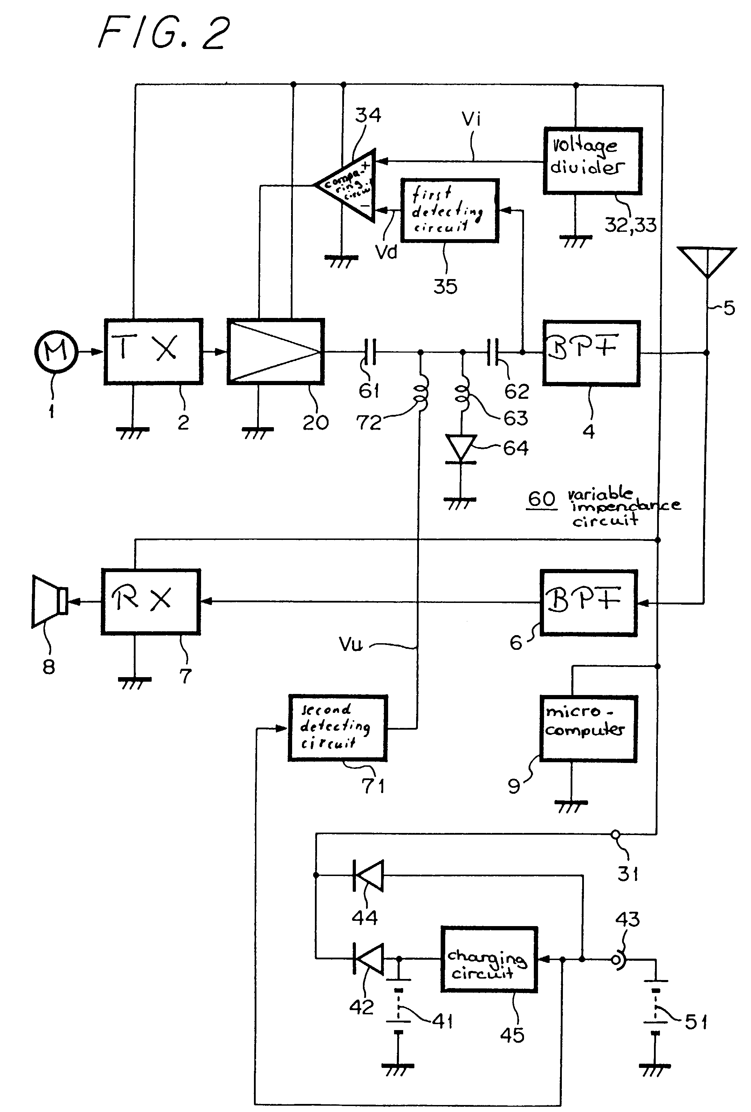

An embodiment of the radio transmitter apparatus according to the present invention will hereinafter be described with reference to the drawings. In Fig. 2 which shows an over all arrangement of the embodiment, like parts corresponding to those of Fig. 1 are marked with the same references and therefore need not be described in detail.

In Fig. 2, reference numeral 42 designates a housed battery and this battery 41 is of the rechargeable type battery, for example, nickel-cadmium battery. This battery 41 is connected to a terminal 31 through a reverse current blocking diode 42. Reference numeral 43 designates an external power terminal. This terminal 43 is connected to the terminal 31 via a reverse current blocking diode 44 and also connected to the battery 41 through a charging circuit 45.

When this mobile station is installed on the automobile in use, as shown in Fig. 2, a car battery 51 is connected to the terminal 43.

Further, reference numeral 60 generally designates a variable impedance circuit, wherein capacitors 61 and 62 are connected in series to a transmission signal line laid between the transistor 23 at the final stage of the power amplifier 20 and the bandpass filter 4, and a coil 63 and a switching diode 64 are connected in series between the junction of the capacitors 61 and 62 and the ground.

Further, a second detecting circuit 71 for detecting the voltage of the battery 51 is connected to the terminal 43, and this second detecting circuit 71 derives a detected voltage Vu which goes "1" when the battery 51 is connected to the terminal 43 and which goes "0" when the battery 51 is not connected to the terminal 43. This detected voltage Vu is supplied through a high frequency choke coil 72 to a junction among the elements 61 to 63.

According to the above arrangement, when this mobile station is not mounted on the automobile, the battery 51 is not connected but at that time the voltage of the battery 41 is supplied through the diode 42 and the terminal 31 to the respective portions of the mobile station as an operation voltage.

Further, at that time, since Vu = "0", the diode 64 is in its off state, which is equal to the fact that the coil 63 is not connected.

Accordingly, if the input impedance of the bandpass filter 4 is determined beforehand, the load impedance of the power amplifier 20 will become, for example, 50 Ω so that the transmission is carried out at the maximum efficiency. That is, when the mobile station is driven by the housed battery 41, the transmission can be made at the maximum efficiency.

On the other hand, when this mobile station is mounted on the automobile, the car battery 51 is connected to the terminal 43, whereby the voltage of the battery 51 is supplied through the diode 44 and the terminal 31 to the respective portions in the mobile station as an operation voltage. Also, the voltage of the battery 51 is charged to the battery 41 through the charging circuit 45.

Further, at that time, since Vu = "1", the diode 64 is in its on state, which is equal to the fact that the coil 63 is connected.

Accordingly, if the value of the coil 63 is determined beforehand, then the load impedance of the power amplifier 20 at that time will become an optimum value to enable the transmission to be carried out at the maximum efficiency. That is, when the mobile station is driven by the battery 51 of the automobile, the transmission can be carried out at the maximum efficiency.

As described above, according to the present invention, by the variable impedance circuit 60 and the second detecting circuit 71, the load impedance of the power amplifier 20 is switched to the optimum value when the power source is the housed battery 41 or the battery 51 of the automobile. Thus, even when the mobile station is driven by using the housed battery 41, the transmission is carried out at the highest efficiency so that the service life of the housed battery 41, i.e., the telephone communication time can be prevented from being reduced.

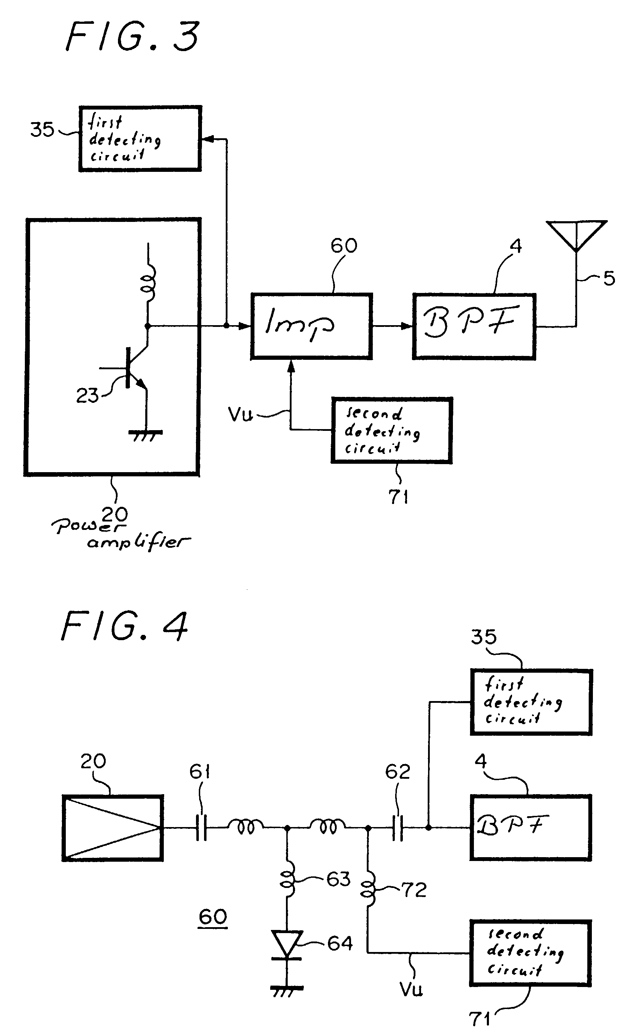

Fig. 3 shows a part of the radio transmitter apparatus of the present invention wherein the connected position of the impedance circuit 60 is changed, and Fig. 4 shows a part of the radio transmitter apparatus in which when the diode 64 is in its on state, the impedance of the impedance circuit 60 is switched by utilizing the fact that the diode 64 has a capacitance when it is in its off state.

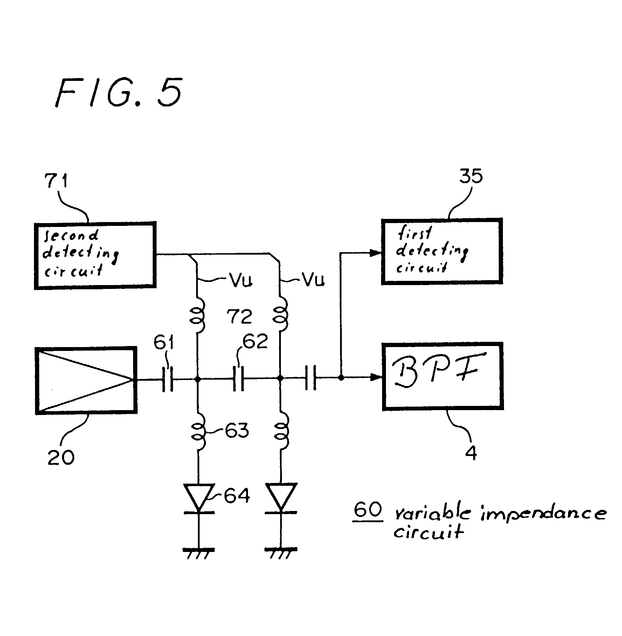

Fig. 5 shows a part of another embodiment of the radio transmitter apparatus according to the present invention in which the impedance circuit 60 is connected in a multiple stage fashion. In this embodiment, the detecting circuit 71 derives the first detected voltage Vu and a second detected voltage Vv in response to the voltage at the terminal 43, and on the basis of the combinations of the detected voltages Vu and Vv, the load impedance of the power amplifier 20 is switched in three steps. Accordingly, in that case, when the mobile station is driven by other power source than the housed battery 41 and the car battery 51, the transmission can be carried out at the highest efficiency.

Alternatively, the voltage at the terminal 31 is detected by the detecting circuit 71 three steps so that, when the voltage of the housed battery 41 and of the car battery 51 is lowered, the transmission can be carried out at high efficiency by switching the load impedance of the power amplifier 20 regardless of the lowered voltage of the battery.

Incidentally, in the above arrangement, when the voltage Vi is switched by the microcomputer 9, the impedance circuit 60 can be switched in multiple steps.

As described above, according to the present invention, by the variable impedance circuit 60 and the detecting circuit 71, the load impedance of the power amplifier 20 is switched to the optimum value when the power source is the housed battery 41 or the battery 51 of the automobile. Thus, even when the mobile station is driven by using the housed battery 41, the transmission is carried out at the highest efficiency so that the service life of the housed battery 41, i.e., the telephone communication time can be prevented from being reduced.

## Claims

1. A radio transmitter apparatus for transmitting a signal by utilizing a battery (51) as a power source, comprising:
a variable impedance circuit (60) provided between a power amplifier (20) and a transmission antenna (5) of said radio transmitter apparatus; and
a detecting circuit (71) for detecting a voltage of said battery (51), wherein said variable impedance circuit (60) is controlled by a detected output of said detecting circuit (71) so that a load impedance of said power amplifier (20) in said radio transmitter apparatus is switched in response to the voltage of said battery (51).

2. A radio transmitter apparatus according to claim 1 for transmitting a signal by selectively utilizing batteries of two sets as a power source,
**characterized in that**
the load impedance of said power amplifier (20) in said radio transmitter apparatus is switched in response to a voltage of a battery (51) selected from said batteries.

## Patentansprüche

1. Funksendegerät zur Übertragung eines Signales unter Verwendung einer Batterie (51) als eine Energiequelle, das folgendes aufweist:
eine veränderbare Impedanzschaltung (60), die zwischen einem Leistungsverstärker (20) und einer Übertragungsantenne (5) des Funksendegerätes bereitgestellt ist; und
eine Detektionsschaltung (71) zur Detektion einer Spannung der Batterie (51), worin die veränderbare Impedanzschaltung (60) gesteuert wird durch ein detektiertes Ausgangssignal der Detektionsschaltung (71), so daß eine Belastungsimpedanz des Leistungsverstärkers (20) in dem Funksendegerät in Abhängigkeit von der Spannung der Batterie (51) geschaltet wird.

2. Funksendegerät nach Anspruch 1 zur Übertragung eines Signales durch selektive Verwendung von Batterien von zwei Sätzen als eine Energiequelle, dadurch gekennzeichnet, daß
die Belastungsimpedanz des Leistungsverstärkers (20) in dem Funksendegerät in Abhängigkeit von einer Spannung einer Batterie (51), die unter den Batterien ausgewählt worden ist, geschaltet wird.

## Revendications

1. Appareil d'émetteur radio pour émettre un signal en utilisant un accumulateur (51) en tant que source d'alimentation, comprenant:
un circuit d'impédance variable (60) prévu entre un amplificateur de puissance (20) et une antenne d'émission (5) dudit appareil d'émetteur radio ; et
un circuit de détection (71) pour détecter une tension dudit accumulateur (51), dans lequel ledit circuit d'impédance variable (60) est commandé par une sortie détectée dudit circuit de détection (71) de telle sorte qu'une impédance de charge dudit amplificateur de puissance (20) dans ledit appareil d'émetteur radio soit commutée en réponse à la tension dudit accumulateur (51).

2. Appareil d'émetteur radio selon la revendication 1 pour émettre un signal en utilisant sélectivement des accumulateurs de deux jeux en tant que source d'alimentation, caractérisé en ce que :
l'impédance de charge dudit amplificateur de puissance (20) dans ledit appareil d'émetteur radio est commutée en réponse à une tension d'un accumulateur (51) choisi parmi lesdits accumulateurs.
